# EUROPEAN PATENT SPECIFICATION

(11) **EP 1 737 274 B1**
(45) Date of publication and mention of the grant of the patent: **09.01.2008**
(21) Application number: 06115675.8
(22) Date of filing: 19.06.2006
(51) Int. Cl.: H05B 33/06, H01L 51/52

(54) **Electroluminescent device**
Elektrolumineszierende Vorrichtung
Dispositif électroluminescent

(30) Priority: 20.06.2005 JP 2005178894
(43) Date of publication of application: 27.12.2006
(73) Proprietor: Kabushiki Kaisha Toyota Jidoshokki, Kariya-shi, Aichi 448-8671 (JP)
(72) Inventor: Kawauchi, Hiroyasu, Kariya-shi Aichi 448-8671 (JP); Harada, Masayuki, Kariya-shi Aichi 448-8671 (JP)
(74) Representative: TBK-Patent

(56) References cited:
- EP-A- 1 246 509
- PATENT ABSTRACTS OF JAPAN vol. 2000, no. 26, 1 July 2002 (2002-07-01) -& JP 2001 244069 A (SEIKO EPSON CORP), 7 September 2001 (2001-09-07)
- PATENT ABSTRACTS OF JAPAN vol. 2000, no. 11, 3 January 2001 (2001-01-03) -& JP 2000 231992 A (STANLEY ELECTRIC CO LTD), 22 August 2000 (2000-08-22)
- PATENT ABSTRACTS OF JAPAN vol. 1998, no. 11, 30 September 1998 (1998-09-30) & JP 10 178214 A (SANYO ELECTRIC CO LTD), 30 June 1998 (1998-06-30)

## Description

### BACKGROUND OF THE INVENTION

The present invention relates to an electroluminescent (EL) device and more particularly to an EL device having a substantially rectangular electroluminescent (EL) layer.

An EL device generally includes an EL layer as a luminescent layer, an anode and a cathode. The anode is formed on one surface of the EL layer and connected to an anode terminal. The cathode is formed on the other surface of the EL layer and connected to a cathode terminal. The EL device is so formed that the EL layer is interposed between the area of the anode in contact with the EL layer (the contact area of the anode) and the area of the cathode in contact with the EL layer (the contact area of the cathode). The anode terminal is connected to an external power source through the anode conductor and the cathode terminal is connected to the external power source through the cathode conductor, and then a voltage is applied between the anode and the cathode. Thus, the EL device is capable of emitting light. When a voltage is applied between the anode and the cathode, holes are injected from the contact area of the anode into the EL layer and electrons are injected from the contact area of the cathode into the EL layer. The holes recombine with the electrons to excite a luminescent body in the EL layer, thereby the EL device emits light.

The EL device will have a luminescent face of desired shape by changing the shape of the EL layer. EL devices having a rectangular or linear EL layer in plan view have been getting a lot of attention recently, which is disclosed in Japanese patent application publication No. 2001-244069. The EL device in the above publication has an elongated anode terminal and an elongated cathode terminal which are aligned along the same short side of the rectangular EL layer.

This arrangement disadvantageously causes a large amount of electric current flowing from an electrode near one short side of the EL layer and a small amount of electric current flowing from an electrode near the other short side of the EL layer. Thus, the EL layer emits light more brightly near one short side where a large amount of electric current flows than near the other short side where a small amount of electric current flows. Specifically, as the long side of the EL layer becomes longer, a difference in brightness, that is, uneven brightness, gets more remarkable in the long side direction of the EL layer.

The present invention is directed to reducing uneven brightness in an EL device having a substantially rectangular EL layer, as compared to the prior art.

### SUMMARY OF THE INVENTION

In accordance with the present invention, an electroluminescent device has an electroluminescent layer, a first electrode and a second electrode. The electroluminescent layer has a substantially rectangular shape in plan view. The first electrode is connected to one surface of the electroluminescent layer and includes a first contact area in contact with one surface of the electroluminescent layer and a first terminal connected to the first contact area and connected to an external first conductor. The second electrode is connected to the other surface of the electroluminescent layer and includes a second contact area in contact with the other surface of the electroluminescent layer and a second terminal connected to an external second conductor. The first electrode is made of a material having a higher volume resistivity than that of the second electrode. The first terminal is formed along one long side of the electroluminescent layer. The second contact area and the second terminal are connected on an area elongated from the electroluminescent layer in a long side direction of the electroluminescent layer.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1 is a plan view of an EL device according to a preferred embodiment of the present invention;
FIG. 2 is a sectional view taken along the line II-II in FIG. 1;
FIG. 3 is a sectional view taken along the line III-III in FIG. 1;
FIG. 4 is a sectional view taken along the line IV-IV in FIG. 1;
FIG. 5 is an exploded perspective view of the EL device, showing layers of the EL device according to the preferred embodiment of the present invention;
FIG. 6 is a plan view of an EL device according to an alternative embodiment of the present invention;
FIG. 7 is a plan view of an EL device according to an alternative embodiment of the present invention;
FIG. 8 is a plan view of an EL device according to an alternative embodiment of the present invention;
FIG. 9 is a plan view of an EL device according to an alternative embodiment of the present invention; and
FIG. 10 is a plan view of an EL device according to an alternative embodiment of the present invention.

### DETAILED DESCRIPTION OF THE PREFERRED EMBODIMENTS

The following preferred embodiments of an EL device according to the present invention are applicable. It is noted that the term "long side direction" and "short side direction" means "long side direction of an EL layer" and "short side direction of an EL layer', respectively unless otherwise stated.
(Embodiment 1) The EL device includes a transparent insulating substrate. A cathode terminal and the whole area of an anode are formed on the upper surface of the transparent insulating substrate. An EL layer is formed on the upper surface of a part of the anode. An anode terminal is formed in the area where the EL layer is not formed. The anode terminal is aligned along one long side of the EL layer and extends in the long side direction of the EL layer. A metal layer as a cathode is formed on the upper surface (back surface) of the EL layer and connected to a cathode terminal. The connection between the metal layer and the cathode terntinal is provided on an area elongated from the EL layer in the long side direction.
(Embodiment 2) The cathode includes a first cathode terminal and a second cathode terminal. The first cathode terminal is formed on one long side of the EL layer, and the second cathode terminal is formed on the other long side of the EL layer. The metal layer is connected to the first cathode terminal at one end in the long side direction and connected to the second cathode terminal at the other end in the long side direction.
(Embodiment 3) In the EL device according to Embodiment 1 or 2, the cathode terminal includes an area which is connected to the metal layer and an area which is connected to the conductor. The EL layer and the area which is connected to the metal layer are aligned along the long side of the EL device.
(Embodiment 4) In the EL device according to Embodiment 3, the anode terminal and the area which is connected to the conductor are aligned along the long side of the EL layer.
(Embodiment 5) In the EL device according to Embodiment 3, the area which is connected to the conductor and the area which is connected to the metal layer are aligned in the long side direction of the EL layer. In other words, the area which is connected to the conductor is formed along the short side of the EL layer.

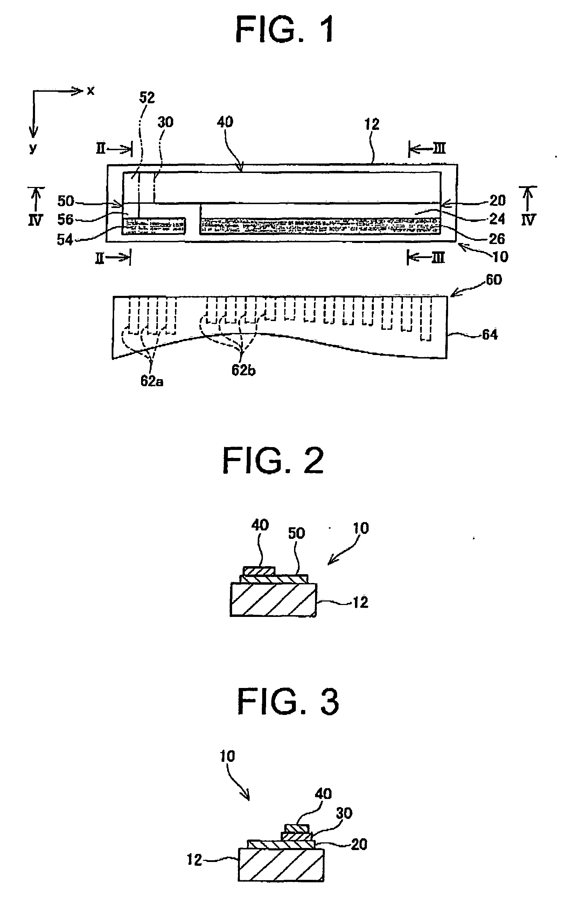

The following will describe a preferred embodiment of an EL device 10 according to the present invention with reference to FIGs. 1 through 5.

As shown in FIGs. 1 through 5, the EL device 10 includes a transparent insulating substrate 12, an anode 20, an EL layer 30, a metal layer 40 and a terminal layer 50. As best shown in FIG. 1, the transparent insulating substrate 12 is rectangular in plan view, extending laterally, that is, in the direction indicated by the arrow x in FIG. 1. As shown in FIGs. 2 through 5, the transparent insulating substrate 12 has a substantially constant thickness. The transparent insulating substrate 12 may be a glass substrate.

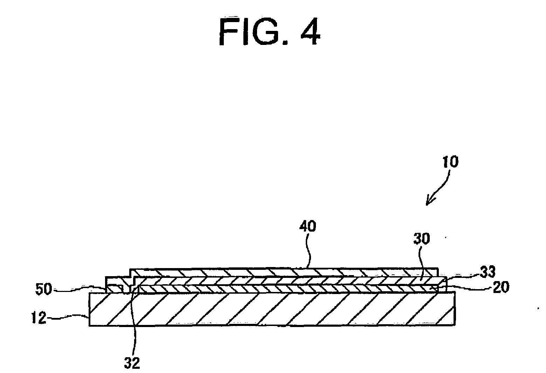

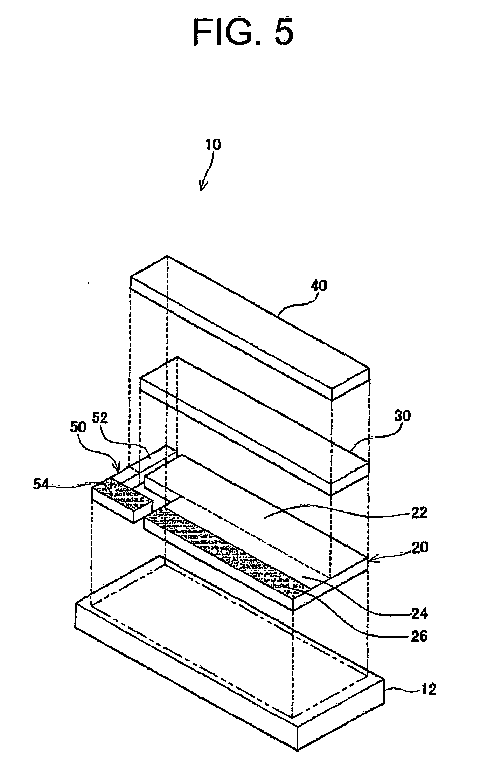

The anode 20 is formed on the upper surface of the transparent insulating substrate 12 and made of transparent and colorless material such as indium tin oxide (or ITO). Note that in this preferred embodiment the term "upper surface" indicates a surface on the upper side with respect to the normal of the sheet of FIG. 1, and the term "lower surface" indicates a surface on the lower side with respect to the normal of the sheet of FIG. 1. The anode 20 has a substantially constant thickness as shown in FIG 4. The anode 20 is substantially L-shaped in plan view as shown in FIG. 5. In other words, referring to FIG. 5, the anode 20 has a laterally extended portion 22 extending almost over the entire breadth of the transparent insulating substrate 12 and a downward extended portion 24 extending downward (in the direction indicated by the arrow y in FIG. 1) from the laterally extended portion 22 mainly on the right side thereof. The lower end of the downward extended portion 24 is used as an anode terminal 26 which is highlighted with a solid color in FIGs. 1 and 5. The anode terminal 26 extends laterally (in the direction indicated by the arrow x in FIG. 1) along the lower long side of the transparent insulating substrate 12. A flexible printed circuit 60 (which is referred to as FPC and will be described later) will be adhered onto the upper surface of the anode terminal 26. When the FPC 60 is adhered on the anode terminal 26, the positive terminals 62b of the FPC 60 are then electrically connected to the anode terminal 26 of the anode 20.

The EL layer 30 is formed on the upper surface of the laterally extended portion 22 of the anode 20 as clearly shown in FIG. 5. The EL layer 30 is formed in a substantially rectangular shape extending laterally in plan view as shown in FIGs. 1 and 5. The EL layer 30 has a substantially constant thickness as shown in FIGs. 3 and 4. Referring to FIG. 4, edges 32, 33 of the EL layer 30 project laterally from the side boundary of the anode 20 to be formed directly on the transparent insulating substrate 12. This protects the anode 20 from short circuit with the metal layer 40. The EL layer (organic luminescent layer) uses a luminescent material such as Alq3 to emit monochromatic light such as red, green and yellow or to emit luminescent color such as white light using a combination of red, green and yellow. White light may be obtained by bilaminar or trilaminar luminescent layers, a unilaminar luminescent layer containing different luminescent materials mixed with each other, or a unilaminar layer consisting of different luminescent layers defined therein. In addition, a functional layer such as a charge (hole or electron) injection layer, a charge transport layer and a blocking layer may be used in combination with the luminescent layer.

The cathode includes the metal layer 40 formed on the upper surface of the EL layer 30 and the terminal layer 50 formed on the upper surface of the transparent insulating substrate 12. The metal layer 40 has a substantially rectangular shape in plan view as shown in FIG. 1 with a substantially constant thickness as shown in FIG. 4. The major part of the metal layer 40 is formed on the upper surface of the EL layer 30. As best shown in FIGs. 4 and 5, the metal layer 40 extends beyond the side boundary of the EL layer 30 toward the terminal layer 50 at one end to be formed on the transparent insulating substrate 12 and the terminal layer 50. Thus, the metal layer 40 and the terminal layer 50 are connected with each other on an area elongated from the transparent insulating substrate 12 (or the EL layer 30) in the long side direction. The metal layer 40 is made of a material having a lower volume resistivity than that of the anode 20, such as ITO. The metal layer 40 may be a reflective metal such as aluminum, gold, silver and chromium or an alloy of these metals which at least reflects visible light. As shown in FIG. 4, the EL layer edge 32 is interposed between the anode 20 and the terminal layer 50 to prevent electric current from directly flowing from the anode 20 to the cathode (which corresponds to the metal layer 40 and the terminal layer 50).

The terminal layer 50 is formed on the transparent insulating substrate 12. The terminal layer 50 is substantially L-shaped in plan view as shown in FIG. 1 with a substantially constant thickness as shown in FIG. 2. The terminal layer 50 may be made of the same material as the anode 20. If the anode 20 is made of ITO, the terminal layer 50 may also be made of ITO. Thus, the cathode includes the metal layer 40 having a low volume resistivity and the terminal layer 50 having a high volume resistivity. The cathode is mostly formed of the metal layer 40 having a low volume resistivity, so that the cathode as a whole has a lower resistance than the anode 20.

As best shown in FIG. 1, the terminal layer 50 includes a first connection 54 and a second connection 56 extending upward in FIG. 1 from the left end of the first connection 54. The first connection 54 extends in the long side direction of the transparent insulating substrate 12 along one long side of the transparent insulating substrate 12. Therefore, the first connection 54 and the anode terminal 26 of the anode 20 are aligned and spaced in the long side direction of the transparent insulating substrate 12. The FPC 60 will be adhered onto the upper surface of the first connection 54. When the FPC 60 is adhered on the first terminal 54, the negative terminals 62a of the FPC 60 are electrically connected to the first connection 54. The upper end of the second connection 56 is used as a connection area 52. The metal layer 40 is formed on the connection area 52 to electrically connect the metal layer 40 with the terminal layer 50. The connection area 52 extends in the short side direction of the transparent insulating substrate 12 along the short side of the transparent insulating substrate 12.

As described above, the lower surface of the FPC 60 is adhered onto the upper surface of the anode terminal 26 and the upper surface of the first connection 54 of the terminal layer 50 (that is, the cathode terminal) by an anisotropic conductive film. The FPC 60 includes a substrate 64, the negative terminals 62a and the positive terminals 62b. The substrate 64 is made of insulating material. The illustration of the lower portion of the substrate 64 is omitted in FIG. 1, Each of the negative terminals 62a is formed by disposing a conductive material on the lower surface of the substrate 64. Similarly, each of the positive terminals 62b is formed by disposing a conductive material on the lower surface of the substrate 64. As is apparent from FIG. 1, the negative terminals 62a and the positive terminals 62b extend up and down in FIG. 1. It is also apparent from FIG. 1 that the breadth (long side width) of the anode terminal 26 is greater than the breadth (long side width) of the first connection 54 of the terminal layer 50 (cathode). For this reason, the number of positive terminals 62b is greater than the number of negative terminals 62a. The breadth (lateral width) of the FPC 60 is a little narrower than the breadth of the EL device 10 (that is, the breadth of the transparent insulating substrate 12). This allows the FPC 60 to be fitted within the breadth of the EL device 10 when adhered thereto.

To allow the EL device 10 to emit light, the negative terminals 62a and the positive terminals 62b are connected to an external power source (not shown). As a forward voltage is applied between the cathode (that is, the metal layer 40) and the anode 20 through the negative terminals 62a and the positive terminals 62b, electric current flows into the EL layer 30, thereby the EL layer 30 emits light. The breadth of the anode terminal 26 (that is, the long side width of the EL layer 30) is considerably wider than the breadth of the first connection 54 (that is, the width of the connection between the cathode and the FPC 60). This contributes to a small difference in voltage applied at positions in the long side direction of the anode 20 (that is, the positions where the positive terminals 62b of the FPC 60 are connected), with the result that a difference in electric current in the long side direction of the EL layer 30 is reduced. This reduces uneven brightness of the EL layer 30. The narrow breadth of the first connection 54 of the cathode (which corresponds to the metal layer 40 and the terminal layer 50) than the anode terminal 26 does not increase an electric potential difference in the breadth direction of the cathode (that is, the metal layer 40) if the connection between the cathode and the FPC 60 does not extend in the breadth direction of the EL layer 30- This is because the cathode has a lower resistance than the anode 20. Therefore, the narrow breadth of the first connection 54 little affects brightness of the EL layer 30. In the EL layer 30, the length in the short side direction is shorter than the length in the long side direction. Uneven intensity of light in the short side direction of the EL layer 30 may be reduced to a problem-free level by decreasing the length in the short side direction of the EL layer 30 to a specified extent. According to the EL device 10 of the preferred embodiment, uneven brightness of the EL layer 30 may be reduced as a whole.

As is clear from the above description, in the EL device 10, the anode terminal 26 extends along the long side direction of the EL layer 30 to have a wide breadth. This reduces a difference in electric current flowing at positions in the long side directions of the EL layer 30, so that uneven brightness of the EL layer 30 is reduced. In the EL device 10 of the preferred embodiment, the first connection 54 of the terminal layer 50 and the anode terminal 26 are aligned along the same long side of the EL device 10. This allows the FPC 60 to be adhered from one side of the EL device 10 for easy connection between the EL device 10 and the FPC 60.

Additionally, the first conductor and the second conductor may be provided on the same conductor substrate for easy connection between the EL device and the conductor substrate. Furthermore, in the EL device 10 of the preferred embodiment, the metal layer 40 and the terminal layer 50 are connected with each other on an area elongated from the EL layer 30 in the long side direction. This allows the first connection 54 of the terminal layer 50 to be adjacent to the anode 20, with the result that the short side width of the EL device 10 (transparent insulating substrate 12) may be reduced. In other words, the metal layer 40 and the terminal layer 50 need an area for connection (the connection area 52). As the connection area 52 is provided at the lower side (the lower side in FIG. 1) of the EL layer 30, the anode 20 (or the EL layer 30), the connection area 52 and the first connection 54 are aligned from the top in the short side direction of the EL layer 30.

On the other hand, when the metal layer 40 and the terminal layer 50 are connected on an area elongated from the EL layer 30 in the long side direction, the connection area 52 is on an area elongated from the EL layer 30 in the long side direction, and the anode 20 (the EL layer 30) and the first connection 54 are aligned in the short side direction of the EL layer 30. This allows the first connection 54 to be adjacent to the anode 20, with the result that the short side width of the EL device 10 may be reduced. The EL device 10 of the preferred embodiment is applicable to a light source having a narrow short side width, for example, for a scanner used for a copier or, a facsimile.

The present invention is not limited to the embodiment described above but may be modified into the following alternative embodiments.

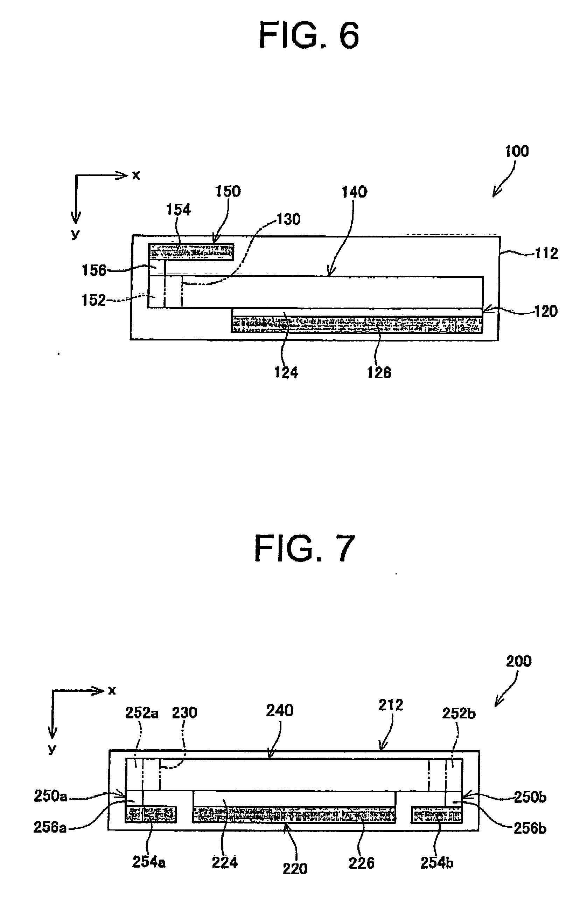

In an alternative embodiment referring to FIG. 6, an EL device 100 includes a transparent insulating substrate 112, an anode 120, an EL layer 130, a metal layer 140 and a terminal layer 150. The anode 120 has a downward extended portion 124 extending downward (in the direction indicated by the arrow y) in FIG. 6. The downward extended portion 124 has an anode terminal 126 at its lower end. The terminal layer 150 includes a first connection 154 and a second connection 156 extending downward (downward in FIG. 6) from the left end of the first connection 154. The second connection 156 has a connection area 152 at its lower end, on which the metal layer 140 is formed. In other words, the first connection 154 for connection with an FPC may be formed along the long side opposite to the side where the anode terminal 126 is formed. This configuration also reduces a difference in electric current flowing at positions in the long side direction of the EL layer 130, so that uneven brightness in the EL layer '130 is reduced.

Furthermore, it is also applicable that the first terminal is formed along one long side of the EL layer and the second terminal is formed along the other long side of the EL layer. This configuration allows the longer first terminal and the longer second terminal to be formed along the long side of the EL layer, with the result that a difference in electric current flowing at positions in the long side direction of the EL layer is reduced.

In an alternative embodiment of an EL device 200 referring to FIG. 7, terminal layers 250a, 250b may be formed on either end of the EL device 200. The terminal layers 250a, 250b have connection areas 252a, 252b formed on the lower surface of either end of the metal layer 240, respectively. First connections 254a, 254b are formed and connected to the lower ends of second connections 256a, 256b, which are formed at the lower side of the connection areas 252a, 252b, respectively. The first connection 254a, an anode terminal 226 formed at the lower end of a downward extended portion 224 that extends downward (in the direction indicated by the arrow y in FIG. 7) of the anode 220, and the first connection 254b are formed along the long side of he transparent insulating substrate 212 in this order.

According to the above configuration, electric current flows from the FPC (not shown) into the middle portion of the anode 220, passes through the EL layer 230 and then returns through the terminal layers 250a, 250b to the FPC. This reduces a difference in electric current flowing at positions in the long side direction of the EL layer 230, so that uneven brightness in the EL layer 230 is reduced- Since an FPC having positive terminals for connection with the anode terminal and an FPC having negative terminals for connection with the cathode terminal will be connected from the same side, the short side width is reduced. As a matter of course, the above FPCs may be integrated into one FPC.

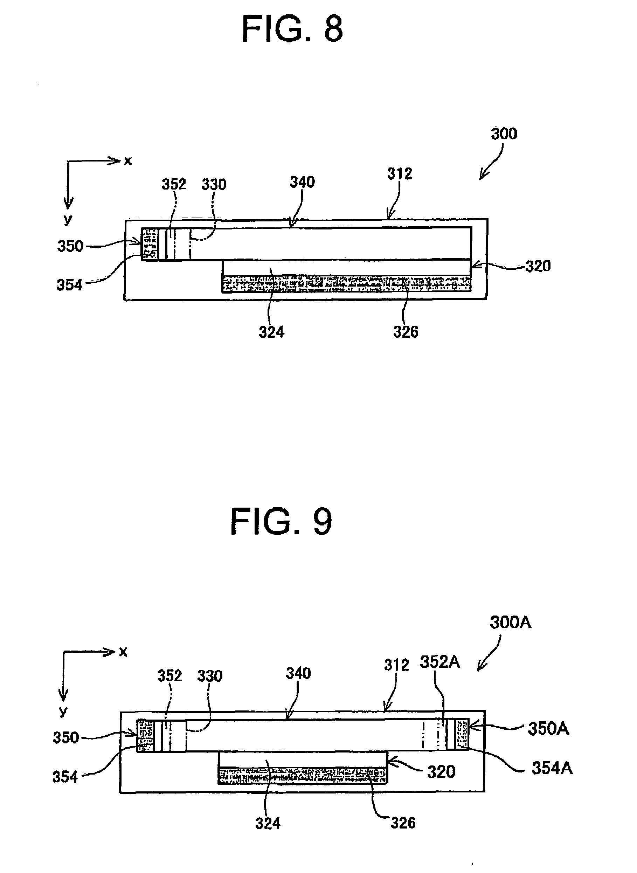

In an alternative embodiment of an EL device 300 referring to FIG. 8, a first connection 354 of a terminal layer 350 (that is, a connection with the FPC) may be formed along the short side of a transparent insulating substrate 312. In the EL device 300, an anode 320 is formed on the transparent insulating substrate 312 and includes a downward extended portion 324 extending downward (in the direction indicated by the arrow y in FIG. 8) and an anode terminal 326 formed and connected to the lower end of the downward extended portion 324. An EL layer 330 is formed on the upper surface of the anode 320. A metal layer 340 is formed on the upper surface of the EL layer 330. The terminal layer 350 may be formed on either end of the EL layer 330. As shown in FIG. 9, an EL device 300A includes another first connection 354A of a terminal layer 350A for connection with an FPC, which is formed along the other short side of the transparent insulating substrate 312.

According to the above configuration, the shape of the connection between the connection area 352 and the first connection 354 for forming the terminal layer 350 and the shape of the connection between the connection area 352A and the first connection 354A for forming the terminal layer 350A are substantially rectangular. This simplifies the shape of the cathode and reduces a space for forming the terminal layers 350, 350A. Additionally, the short side width may be reduced. Furthermore, the anode terminal may be as long as the EL layer.

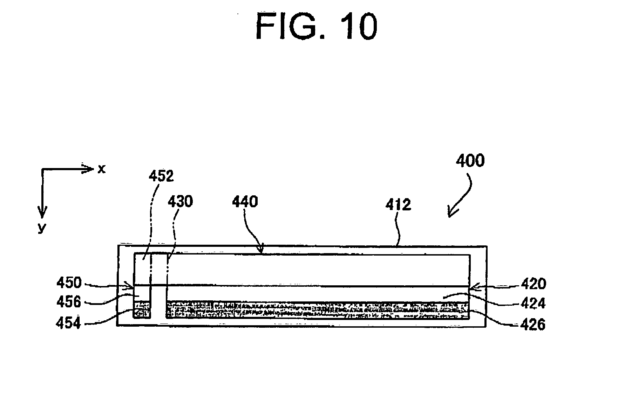

In the above embodiments, the breadth (long side width) of the anode terminal is narrower than the breadth (long side width) of the EL layer. However, a position or shape of the cathode may be changed to obtain the breadth of the anode terminal substantially equal to the breadth of the EL layer. In an alternative embodiment of an EL device 400 referring to FIG. 10, a connection area 452 formed on the lower surface of a metal layer 440, a second connection 456 formed and connected to the lower end of the connection area 452, and a terminal layer 450 having a first connection 454 are formed in a rectangular shape along the short side of a transparent insulating substrate 412. Thus, the first connection 454 is not formed to extend toward the anode 420, and the anode terminal 426 formed at the lower end of the downward extended portion 424 extending downward (in the direction indicated by the arrow y in FIG. 10) of the anode 420 may be substantially equal to the breadth(long side width) of the EL layer 430. This configuration reduces a difference in electric current flowing at positions in the long side directions of the EL layer 430, so that uneven brightness in the EL layer 430 is reduced.

Therefore, the present examples and embodiments are to be considered as illustrative and not restrictive, and the invention is not to be limited to the details given herein but may be modified within the scope of the appended claims.

An electroluminescent device has a substantially rectangular electroluminescent layer in plan view, and first and second electrodes. The first electrode connected to one surface of the electroluminescent layer includes a first contact area in contact with one surface of the electroluminescent layer and a first terminal connected to the first contact area and to an external first conductor. The second electrode connected to the other surface of the electroluminescent layer includes a second contact area in contact with the other surface of the electroluminescent layer and a second terminal connected to an external second conductor. The material of the first electrode is higher in volume resistivity than that of the second electrode. The first terminal is formed along one long side of the electroluminescent layer. The second contact area and the second terminal are connected on an area elongated from the electroluminescent layer in a long side direction thereof.

## Claims

1. An electroluminescent device comprising an electroluminescent layer having a substantially rectangular shape in plan view, a first electrode connected to one surface of the electroluminescent layer and a second electrode connected to the other surface of the electroluminescent layer, **characterized in that:**
the first electrode includes a first contact area in contact with one surface of the electroluminescent layer and a first terminal connected to the first contact area and to an external first conductor, **in that** the first terminal is formed along one long side of the electroluminescent layer, **in that** the second electrode includes a second contact area in contact with the other surface of the electroluminescent layer and a second terminal connected to an external second conductor, **in that** the first electrode is made of a material having a higher volume resistivity than that of the second electrode, and **in that** the second contact area and the second terminal are connected on an area elongated from the electroluminescent layer in a long side direction of the electroluminescent layer.

2. The electroluminescent device according to claim 1, wherein the first terminal and the second terminal are formed along the same long side of the electroluminescent layer.

3. The electroluminescent device according to claim 1, wherein the second terminal is formed along one short side of the electroluminescent layer.

4. The electroluminescent device according to claim 3, wherein the second terminal is formed along either short side of the electroluminescent layer.

5. The electroluminescent device according to any one of claims 1 through 4, wherein the width of the first terminal in the long side direction of the electroluminescent layer is substantially equal to the long side width of the electroluminescent layer.

6. The electroluminescent device according to claim 1, wherein the second terminal is formed along a long side of the electroluminescent layer, which is opposite to the long side where the first terminal is formed.

7. The electroluminescent device according to any one of claims 1 through 6, wherein the electroluminescent layer contains an organic electroluminescent material.

8. The electroluminescent device according to claim 7, wherein the organic electroluminescent material is Alq3.

9. The electroluminescent device according to any one of claims 1 through 8, wherein the first electrode is an anode and the second electrode is a cathode.

10. The electroluminescent device according to any one of claims 1 through 9, wherein the first electrode is made of transparent and colorless material.

11. The electroluminescent device according to claim 10, wherein the transparent and colorless material is indium tin oxide.

12. The electroluminescent device according to any one of claims 1 through 11, wherein the second terminal is made of the same material as that of the first electrode.

13. The electroluminescent device according to any one of claims 1 through 12, wherein the second contact area is made of a material having a lower volume resistivity than that of the first electrode.

14. The electroluminescent device according to claim 13, wherein the second contact area is made of a reflective metal which at least reflects visible light.

15. The electroluminescent device according to claim 14, wherein the reflective metal is selected from the group consisting of aluminum, gold, silver, chromium and an alloy of these metals.

## Patentansprüche

1. Elektrolumineszierende Vorrichtung mit einer elektrolumineszierenden Schicht, die in einer Draufsicht eine im Wesentlichen rechtwinkelige Form aufweist, einer mit einer Oberfläche der elektrolumineszierenden Schicht verbundenen ersten Elektrode und einer mit der anderen Oberfläche der elektrolumineszierenden Schicht verbundenen zweiten Elektrode, **dadurch gekennzeichnet, dass**:
die erste Elektrode einen ersten Kontaktbereich in Kontakt mit einer Oberfläche der elektrolumineszierenden Schicht und einen mit dem ersten Kontaktbereich und einem externen ersten Leiter verbundenen ersten Anschluss enthält, dass der erste Anschluss entlang einer Längsseite der elektrolumineszierenden Schicht gebildet ist, dass die zweite Elektrode einen zweiten Kontaktbereich in Kontakt mit der anderen Oberfläche der elektrolumineszierenden Schicht und einen mit einem externen zweiten Leiter verbundenen zweiten Anschluss enthält, dass die erste Elektrode aus einem Material gefertigt ist, das einen höheren Volumenwiderstand als jenes der zweiten Elektrode aufweist, und dass der zweite Kontaktbereich und der zweite Anschluss an einem Bereich verbunden sind, der von der elektrolumineszierenden Schicht in einer längsseitigen Richtung der elektrolumineszierenden Schicht verlängert ist.

2. Elektrolumineszierende Vorrichtung gemäß Anspruch 1, wobei der erste Anschluss und der zweite Anschluss entlang der gleichen Längsseite der elektrolumineszierenden Schicht gebildet sind.

3. Elektrolumineszierende Vorrichtung gemäß Anspruch 1, wobei der zweite Anschluss entlang einer Kurzseite der elektrolumineszierenden Schicht gebildet ist.

4. Elektrolumineszierende Vorrichtung gemäß Anspruch 3, wobei der zweite Anschluss entlang von Kurzseiten der elektrolumineszierenden Schicht gebildet ist.

5. Elektrolumineszierende Vorrichtung gemäß einem der Ansprüche 1 bis 4, wobei die Breite des ersten Anschlusses in der längsseitigen Richtung der elektrolumineszierenden Schicht im Wesentlichen gleich der längsseitigen Breite der elektrolumineszierenden Schicht ist.

6. Elektrolumineszierende Vorrichtung gemäß Anspruch 1, wobei der zweite Anschluss entlang einer Längsseite der elektrolumineszierenden Schicht gebildet ist, die der Längsseite gegenüber liegt, bei der der erste Anschluss gebildet ist.

7. Elektrolumineszierende Vorrichtung gemäß einem der Ansprüche 1 bis 6, wobei die elektrolumieszierende Schicht ein organisches elektrolumineszierendes Material enthält.

8. Elektrolumineszierende Vorrichtung gemäß Anspruch 7, wobei das organische elektrolumineszierende Material Alq3 ist.

9. Elektrolumineszierende Vorrichtung gemäß einem der Ansprüche 1 bis 8, wobei die erste Elektrode eine Anode und die zweite Elektrode eine Kathode ist.

10. Elektrolumineszierende Vorrichtung gemäß einem der Ansprüche 1 bis 9, wobei die erste Elektrode aus einem transparenten und farblosen Material gefertigt ist.

11. Elektrolumineszierende Vorrichtung gemäß Anspruch 10, wobei das transparente und farblose Material Indiumzinnoxid ist.

12. Elektrolumineszierende Vorrichtung gemäß einem der Ansprüche 1 bis 11, wobei der zweite Anschluss aus dem gleichen Material wie jenes der ersten Elektrode gefertigt ist.

13. Elektrolumineszierende Vorrichtung gemäß einem der Ansprüche 1 bis 12, wobei der zweite Kontaktbereich aus einem Material gefertigt ist, dass einen niedrigeren Volumenwiderstand als jenes der ersten Elektrode aufweist.

14. Elektrolumineszierende Vorrichtung gemäß Anspruch 13, wobei der zweite Kontaktbereich aus einem reflektierenden Metall gefertigt ist, das zumindest sichtbares Licht reflektiert.

15. Elektrolumineszierende Vorrichtung gemäß Anspruch 14, wobei das reflektierende Metall aus der Gruppe ausgewählt ist, die aus Aluminium, Gold, Silber, Chrom und einer Legierung dieser Metalle besteht.

## Revendications

1. Dispositif électroluminescent comprenant une couche électroluminescente comportant une forme sensiblement rectangulaire en vue en plan, une première électrode connectée à une première surface de la couche électroluminescente et une seconde électrode connectée à l'autre surface de la couche électroluminescente, **caractérisé en ce que** :
la première électrode inclut une première zone de contact en contact avec la première surface de la couche électroluminescente et une première borne connectée à la première zone de contact et à un premier conducteur externe, **en ce que** la première borne est formée le long d'un côté long de la couche électroluminescente, **en ce que** la seconde électrode inclut une seconde zone de contact en contact avec l'autre surface de la couche électroluminescente et une seconde borne connectée à un second conducteur externe, **en ce que** la première électrode est constituée d'un matériau ayant une plus grande résistivité transversale que celle de la seconde électrode, et **en ce que** la seconde zone de contact et la seconde borne sont connectées sur une zone allongée depuis la couche électroluminescente dans la direction du côté long de la couche électroluminescente.

2. Dispositif électroluminescent selon la revendication 1, dans lequel la première borne et la seconde borne sont formées le long du même côté long de la couche électroluminescente.

3. Dispositif électroluminescent selon la revendication 1, dans lequel la seconde borne est formée le long d'un côté court de la couche électroluminescente.

4. Dispositif électroluminescent selon la revendication 3, dans lequel la seconde borne est formée le long de l'un ou l'autre côté court de la couche électroluminescente.

5. Dispositif électroluminescent selon l'une quelconque des revendications 1 à 4, dans lequel la largeur de la première borne dans la direction du côté long de la couche électroluminescente est sensiblement égale à la largeur du côté long de la couche électroluminescente.

6. Dispositif électroluminescent selon la revendication 1, dans lequel la seconde borne est formée le long d'un côté long de la couche électroluminescente, qui est en regard du côté long sur lequel la première borne est formée.

7. Dispositif électroluminescent selon l'une quelconque des revendications 1 à 6, dans lequel la couche électroluminescente contient un matériau organique électroluminescent.

8. Dispositif électroluminescent selon la revendication 7, dans lequel le matériau organique électroluminescent est l'Alq3.

9. Dispositif électroluminescent selon l'une quelconque des revendications 1 à 8, dans lequel la première électrode est une anode et la seconde électrode est une cathode.

10. Dispositif électroluminescent selon l'une quelconque des revendications 1 à 9, dans lequel la première électrode est constituée d'un matériau transparent et incolore.

11. Dispositif électroluminescent selon la revendication 10, dans lequel le matériau transparent et incolore est l'oxyde d'indium étain.

12. Dispositif électroluminescent selon l'une quelconque des revendications 1 à 11, dans lequel la seconde borne est constituée du même matériau que celui de la première électrode.

13. Dispositif électroluminescent selon l'une quelconque des revendications 1 à 12, dans lequel la seconde surface de contact est constituée d'un matériau ayant une plus petite résistivité transversale que celle de la première électrode.

14. Dispositif électroluminescent selon la revendication 13, dans lequel la seconde zone de contact est constituée d'un métal réflecteur qui reflète au moins la lumière visible.

15. Dispositif électroluminescent selon la revendication 14, dans lequel le métal réflecteur est sélectionné parmi le groupe constitué d'aluminium, or, argent, chrome et un alliage de ces métaux.
